# EUROPEAN PATENT SPECIFICATION

(11) **EP 0 590 716 B1**
(45) Date of publication and mention of the grant of the patent: **07.01.1998**
(21) Application number: 93202741.0
(22) Date of filing: 23.09.1993
(51) Int. Cl.: H02M 3/335, H03K 17/04

(54) **Drive circuit for a flyback converter with switching transistors in bridge arrangement**
Treiberschaltung für Sperrwandler mit brückenangeordneten Schalttransistoren
Circuit de commande pour convertisseur à récupération avec transisteurs de commutation en configuration de pont

(30) Priority: 02.10.1992 EP 92203026
(43) Date of publication of application: 06.04.1994
(73) Proprietor: Philips Electronics N.V., 5621 BA Eindhoven (NL)
(72) Inventor: Heeringa, Schelte, NL-5656 AA Eindhoven (NL); Bosscha, Geert Jan, NL-5656 AA Eindhoven (NL)
(74) Representative: Schoonheijm, Harry Barend

(56) References cited:
- EP-A- 0 309 867
- DE-A- 3 040 365
- DE-A- 4 035 969
- US-A- 4 630 186
- 2ND ANNUAL IEEE APPLIED POWER ELECTRONICS CONFERENCE, February 1987, SAN DIEGO, CALIFORNIA, USA pages 37 - 43 N.J. BARBAS 'Cascode Switching Element with Proportional Drive Assures Low Losses and Enhances Feasibility.'

## Description

The invention relates to a drive circuit for driving a control electrode of a switching transistor having a main current path in series with a primary winding of a transformer connected between a first and a second power supply terminal, which drive circuit comprises:
a starting resistor connected between the control electrode of the switching transistor and the first power supply terminal,
a secondary winding of the transformer having a first terminal and a second terminal, which second terminal is connected to a first main electrode of the switching transistor in a node,
a coupling capacitor and a series resistor, which are connected in series between the first terminal of the secondary winding and the control electrode of the switching transistor, and
a discharge diode connected between the second terminal of the secondary winding and a tap of the series resistor.

The invention further relates to a power supply circuit with two switching transistors in bridge arrangement, comprising such a drive circuit.

A drive circuit of the type defined in the opening paragraph is known from United States Patent US 4,652,984. This known drive circuit is used in a flyback converter, the connection from the primary of the transformer to the first and the second power supply terminal being interrupted periodically by means of the switching transistor. The starting resistor causes the switching transistor to be turned on, after which the switching transistor is rapidly driven into saturation by positive feedback *via* the secondary winding, the coupling capacitor and the series resistance. The switching transistor is turned off as soon as the current through this transistor exceeds a given value. The voltage across the secondary winding commutates, *i.e.* its polarity changes, and positive feedback *via* the coupling capacitor and the series resistance helps to turn off the switching transistor. The discharge diode is then conductive and provides a discharging path for the coupling capacitor, which speeds up starting of the switching transistor in the next switching cycle.

The switching transistor and the drive circuit can also be used in a flyback converter comprising two switching transistors in a bridge arrangement. The principle of a bridge arrangement is know from *inter alia* United States Patent US 4,768,141, Fig. 1. The bridge arrangement compnses two switching transistors, of which the first one can connect one terminal of the pnmary to the first power supply terminal and of which the second switching transistor can connect the other terminal of the primary to the second power supply terminal. In order to minimize switching losses the two switching transistors must be driven with maximal synchronism. One switching transistor can then be driven in conventional manner, for example with pulse-width control or in a manner as known from the first-mentioned Patent US 4,652,984 and then forms the master switching transistor. The other switching transistor can then be driven by means of the afore-mentioned known dnve circuit and then forms the slave switching transistor because it is turned on and off by the commutation of the voltage on the secondary winding as a result of the master switching transistor being turned on and off.

A disadvantage is now that the slave switching transistor is turned off comparatively slowly because the discharge diode limits the commutated voltage on the control electrode of this switching transistor to approximately 0.7 V. Moreover, the current required for turning off is limited by that part of series resistance situated between the discharge diode and the control electrode of the slave switching transistor. It is an object of the invention to provide a solution enabling the slave switching transistor to be turned off more rapidly.

To achieve this, in accordance with the invention, a drive circuit of the type defined in the opening paragraph is characterized in that the drive circuit further comprises:
a voltage source having a first voltage terminal connected to the first main electrode of the switching transistor and having a second voltage terminal for supplying a bias voltage which relative to the node is higher than and of the same sign as the forward voltage of the discharge diode, and
a further switching transistor of a conductivity type opposite to the conductivity type of the first-mentioned switching transistor, which further switching transistor has a first main electrode connected to the control electrode of the first-mentioned switching transistor, a second main electrode connected to the voltage terminal and a control electrode coupled to a node between the coupling capacitor and the series resistor.

The drive circuit compnses a further switching transistor which upon commutation of the voltage on the secondary winding connects the control electrode of the first-mentioned switching transistor to the voltage terminal of the voltage source. Since the voltage of this voltage source is higher than the forward voltage of the discharge diode the first-mentioned switching transistor is turned off more rapidly. Moreover, this eliminates the current-limiting effect of the senes resistance.

An embodiment of a dnve circuit in accordance with the invention is characterized in that the voltage source comprises: a rectifier diode and a smoothing capacitor, which are arranged in series between the first terminal and the second terminal of the secondary winding, the voltage terminal being formed by a terminal of the smoothing capacitor, which terminal is coupled to the third rectifier diode. The commutated voltage on the secondary winding is simply and advantageously converted into a direct voltage by means of the rectifier diode and the smoothing capacitor and used as a supply voltage for the further switching transistor.

These and other aspects of the invention will now be described and clarified with reference to the accompanying drawings, in which
Figure 1 is a circuit diagram of a power supply circuit in bridge arrangement with a drive circuit in accordance with the invention,
Figure 2 is a circuit diagram of a part of an alternative drive circuit in accordance with the invention,
Figure 3 shows some diagrams to illustrate the operation of a power supply circuit in bridge arrangement compnsing a drive circuit in accordance with the invention, and
Figure 4 is a circuit diagram of a supplementary circuit for use in a power supply circuit in bridge arrangement comprising a drive circuit in accordance with the invention.

In these Figures parts or elements having the same function or purpose bear the same references.

US-A-4 630 186 discloses a different approach using a voltage source in series with a further switching transistor of opposite conductivity type. One voltage terminal of the voltage source is connected to the control electrode of the first mentioned main switching transistor. The further switching transistor has a first main electrode (emitter) connected to the other voltage terminal of the voltage source, a second main electrode (collector) connected to the first main electrode (emitter) of the first mentioned switching transistor and a control electrode (base) which is driven via a buffer transistor in response to a voltage across a resistor in series with the first main electrode (emitter) of the main switching transistor.

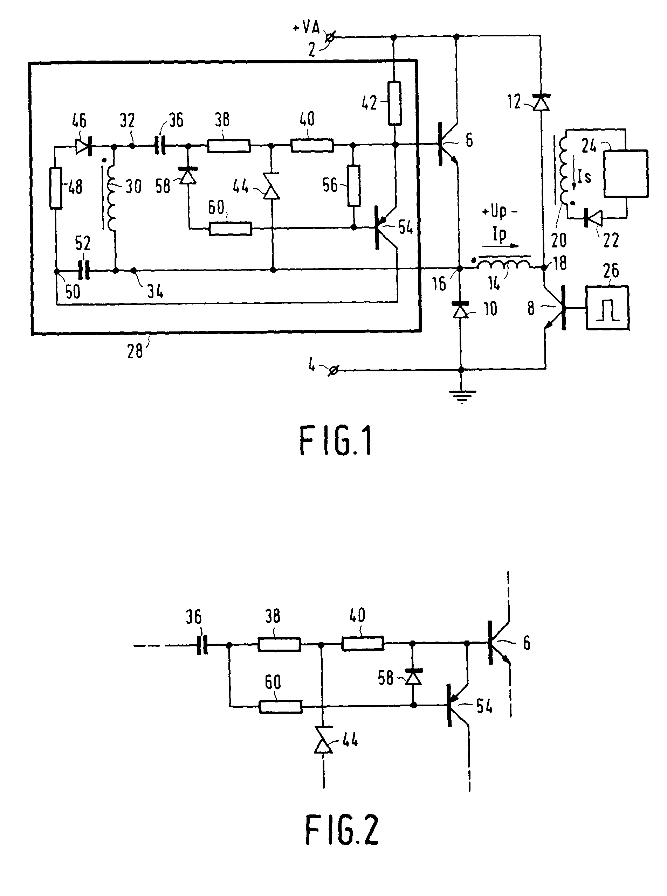

Figure 1 shows a power supply circuit in accordance with the invention. Between a positive power supply terminal 2 and a negative power supply terminal 4, which is connected to earth, the following parts are connected in a bridge arrangement: a first switching transistor 6, a second switching transistor 8, a first rectifier diode 10, a second rectifier diode 12 and a primary winding 14 of a transformer which is not shown as such. The switching transistors 6 and 8 are constructed as, for example, bipolar NPN transistors. The anode of the first rectifier diode 10 is connected to the negative power supply terminal 4. The emitter or first main electrode of the second switching transistor 8 is, for example, also connected to the negative power supply terminal 4. However, depending on the manner in which this transistor is driven, the emitter may alternatively be connected to the negative power supply terminal 4 *via* an impedance. The collector or second main electrode of the first switching transistor 6 and the cathode of the second rectifier diode 12 are connected to the positive power supply terminal 2. The emitter of the first switching transistor 6 and the cathode of the first rectifier diode 10 are connected to one another in a first node 16. The cathode of the second rectifier diode 12 and the collector of the second switching transistor 8 are connected to one another in a second node 18. The primary winding is connected between the nodes 16 and 18. The transformer comprises a first secondary winding 20 to which a load 24 is connected *via* a rectifier diode 22. The cathode of the rectifier diode 22 is connected to that end of the secondary winding 20 which carries a voltage in phase with the voltage on the first node 16. The base or control electrode of the second switching transistor 8 receives its drive from a drive circuit 26 of arbitrary construction. The first switching transistor 6 receives its drive from a drive circuit 28 whose parts are arranged as follows. A second secondary winding 30 of the transformer has a first terminal 32 and a second terminal 34, which second terminal 34 is connected to the first node 16. Alternatively, the secondary winding 30 may be a tap of the primary winding 14. The voltage on the first terminal 32 is in phase with the voltage on the first junction 16. The first terminal 32 is connected to the base or control electrode of the first switching transistor 6 *via* a coupling capacitor 36 and two series resistors 38 and 40, said base being also connected to the positive power supply terminal 2 *via* a starting resistor 42. A zener diode 44 has its cathode connected to the node between the series resistors 38 and 40 and has its anode connected to the first node 16. A rectifier diode 46 has its cathode connected to the first terminal 32 of the secondary winding 30 and has its anode connected to a voltage terminal 50 *via* an optional limiting resistor 48. The voltage terminal 50 is connected to the second terminal 34 of the secondary winding 30 *via* a smoothing capacitor 52. The emitter and the collector of a third bipolar PNP switching transistor 54 are connected to the base of the first switching transistor 6 and the voltage terminal 50 respectively. The base-emitter junction of the third switching transistor 54 is shunted by a resistor 56. The base of the third switching transistor 54 is connected to the node between the coupling capacitor 36 and the series resistor 38 *via* a series arrangement of a diode 58 and a resistor 60, the anode of the diode 58 being situated at the side of the base of the third switching transistor 54. Figure 2 shows an alternative circuit arrangement in which the diode 58 takes the place of the resistor 56 and the resistor 60 is connected between the base of the third switching transistor 54 and the node between the coupling capacitor 36 and the series resistor 38.

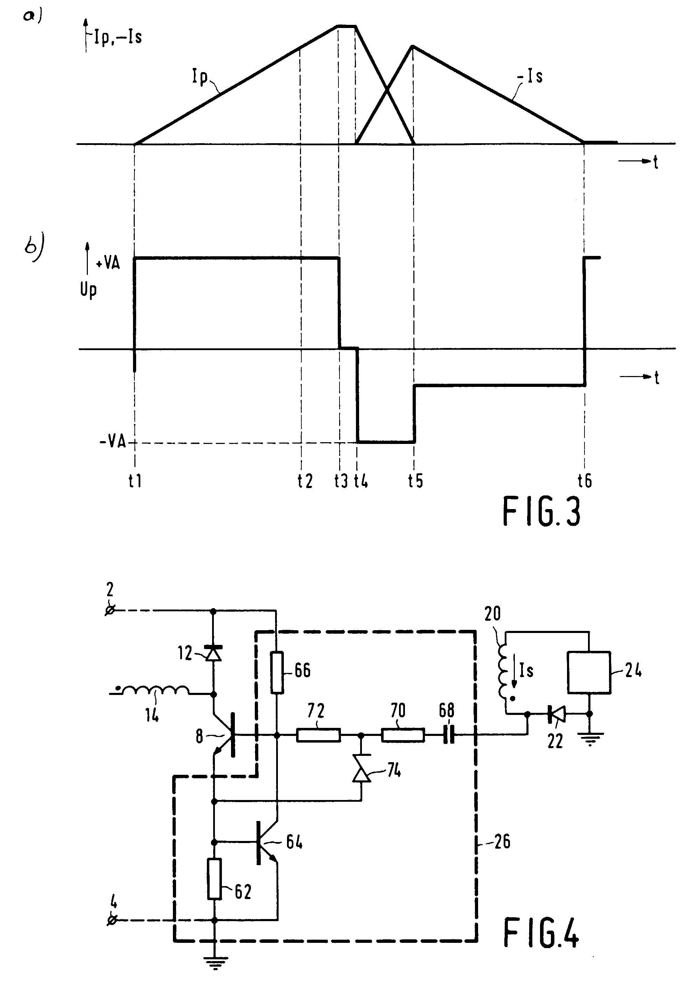

The operation of the power supply circuit will now be explained with reference to Figure 3, in which Figure 3a shows the current Ip through the primary winding 14 and the current -Is through the first secondary winding 20 and Figure 3b shows the voltage Up across the primary winding 14 as a function of time. At the instant t1 the first switching transistor 6 and the second switching transistor 8 are turned on. Substantially the entire supply voltage +VA then appears across the primary winding 14 and the current Ip increases as a linear function of time. At the instant t2 the drive circuit 26 turns off the second switching transistor 8. Briefly after this, at the instant t3, the second switching transistor is really turned off, so that the voltage Up across the primary winding 14 is commutated, *i.e.* its sign is reversed. As a result of this commutation the first switching transistor 6 is also turned off *via* the secondary winding. For a short time interval t3-t4 the current Ip flows through the main current path of the first switching transistor 6 and the second rectifier diode 12. The voltage Up across the primary winding 14 is then substantially zero. If the first switching transistor 6 is fully cut off at the instant t4 the voltage Up is commutated again to a value +VA. Now a current -Is is built up in the secondary winding 20 and *via* the rectifier diodes 10 and 12 the current Ip decreases to zero. At the instant t5 commutation has ceased, after which the current -Is decreases again to zero at the instant t6 in a manner which depends on the type of load 24. At the instant t6 all the energy has been drawn from the transformer and the voltages across the windings become zero. After this, the switching transistors 6 and 8 are turned on again.

Conduction of the first switching transistor 6 is initiated by means of the starting resistor 42. When the two switching transistors 6 and 8 have been turned on the positive supply voltage +VA will appear across the primary winding 14. Owing to the positive feedback *via* the secondary winding 30, the coupling capacitor 36 and the series resistors 38 and 40 the base of the first switching transistor 6 receives an extra positive drive signal, as a result of which the first switching transistor 6 is rapidly saturated. The series resistors 38 and 40 limit the base current of the first switching transistor 6 and the zener diode 44 precludes oversaturation when the supply voltage VA is large. The zener diode 44 may be replaced by a normal diode if this situation does not occur in practice. Upon the commutation at the instant t3 the voltage across the secondary winding 30 first becomes zero and then goes negative, so that the first switching transistor is turned off. The zener diode 44 now functions as a discharge diode for the coupling capacitor 36, as a result of which the first switching transistor 6 is turned on more rapidly in the next switching cycle. However, the negative voltage on the base of the first switching transistor 6 is then limited to -0.7 V. Therefore, turning-off takes a comparatively long time, particularly because the current which can be drawn from the base is also limited by the resistor 40. In the time interval t4-t6 the voltage on the first terminal 32 is negative relative to the voltage on the second terminal 34. The smoothing capacitor 52 is charged to a negative voltage *via* the rectifier diode 46 and the optional limiting resistor 48. The base of the third switching transistor 54 receives a negative drive signal *via* the coupling capacitor 36, the diode 58 and the resistor 60 and the transistor is turned on. The third switching transistor 54 pulls the base of the first switching transistor 6 towards a negative voltage below -0.7 V, as a result of which the first switching transistor 6 is turned off rapidly. The diode 58 prevents the third switching transistor 54 from being driven in the interval t1-t4, whilst the resistor 56 keeps the base-emitter junction of the third switching transistor cut off. The alternative circuit shown in Figure 2 has the same effect.

Figure 4 shows a more detailed circuit diagram of a drive circuit 26 for the second switching transistor 8. The emitter of the second switching transistor 8 is connected to earth by a resistor 62. The base-emitter junction of a fourth switching transistor 64 is connected in parallel with the resistor 62, the emitter being connected to earth. The collector of the fourth switching transistor 64 is connected to the base of the second switching transistor 8, which base is further connected to the positive power supply terminal 2 *via* a starting resistor 66. The node between the first secondary winding 20 and the rectifier diode 22 is connected to the base of the second switching transistor 8 *via* a series arrangement of a coupling capacitor 68, a series resistor 70 and a series resistor 72. The node between the series resistors 70 and 72 is connected to the emitter of the second switching transistor 8 by means of a zener diode 74.

The starting resistor 66, the coupling capacitor 68, the series resistors 70 and 72 and the zener diode 74 operate in the same way and have the same functions as the respective corresponding elements 42, 36, 38, 40 and 44 of the circuit shown in Figure 1. As soon as the current through the second switching transistor has reached a certain value the fourth switching transistor 64 is turned on, thereby connecting the base of the second switching transistor 8 to earth. The second switching transistor 8 is turned off, the voltage across the first secondary winding 20 is commutated and the current Is flows to the load 24 *via* the rectifier diode 22. For the remainder the operation is substantially identical to that of the drive circuit 28 of the first switching transistor 6. Owing to the presence of the resistor 62 and the fourth switching transistor 64 the drive circuit 26 shown in Figure 4 is self-oscillating.

## Claims

1. A drive circuit for driving a control electrode of a switching transistor (6) having a main current path in series with a primary winding (14) of a transformer connected between a first (2) and a second (4) power supply terminal, which drive circuit comprises:
a starting resistor (42) connected between the control electrode of the switching transistor (6) and the first power supply terminal (2),
a secondary winding (30) of the transformer having a first terminal (32) and a second terminal (34), which second terminal (34) is connected to a first main electrode of the switching transistor (6) in a node (16),
a coupling capacitor (36) and a series resistor (38, 40), which are connected in series between the first terminal (32) of the secondary winding (30) and the control electrode of the switching transistor (6), and
a discharge diode (44) connected between the second terminal (34) of the secondary winding (30) and a tap of the series resistor (38, 40), characterized in that the drive circuit further comprises:
a voltage source (46, 48, 52) having a first voltage terminal (34) connected to said node (16) of the first main electrode of the switching transistor (6) and having a second voltage terminal (50) for supplying a bias voltage which relative to the node (16) is higher than and of the same sign as the forward voltage of the discharge diode (44), and
a further switching transistor (54) of a conductivity type opposite to the conductivity type of the first-mentioned switching transistor (6), which further switching transistor (54) has a first main electrode connected to the control electrode of the first-mentioned switching transistor (6), a second main electrode connected to the voltage terminal (50) and a control electrode coupled to a node between the coupling capacitor (36) and the series resistor (38).

2. A drive circuit as claimed in Claim 1, characterized in that the voltage source (46, 48, 52) comprises: a rectifier diode (46) and a smoothing capacitor (52), which are arranged in series between the first terminal (32) and the second terminal (34) of the secondary winding (30), the voltage terminal (50) being formed by a terminal of the smoothing capacitor (52), which terminal is coupled to the third rectifier diode (46).

3. A drive circuit as claimed in Claim 2, characterized in that the control electrode of the further switching transistor (54) is connected to the node between the coupling capacitor (36) and the series resistor (38) *via* a resistor (60), and a diode (58) is arranged across the control electrode and the first main electrode of the further switching transistor (54).

4. A drive circuit as claimed in Claim 2, characterized in that the control electrode of the further switching transistor (54) is connected to the node between the coupling capacitor (36) and the series resistor (38) *via* a series arrangement of a diode (58) and a resistor (60), and a further resistor (56) is arranged across the control electrode and the first main electrode of the further switching transistor (54).

5. A drive circuit as claimed in Claim 1, 2, 3 or 4, characterized in that the discharge diode (44) is a zener diode.

6. A power supply circuit comprising two switching transistors (6, 8) in a bridge arrangement comprising:
a transformer having a pnmary winding (14) connected between a first (16) and a second (18) node;
a first switching transistor (6) having a main current path connected between a first power supply terminal (2) and the first node (16);
a second switching transistor (8) having a main current path connected between the second node (18) and a second power supply terminal (4);
means (26) for driving a control electrode of the second switching transistor (8);
a first unidirectional element (10) connected between the first node (10) and the second power supply terminal (4);
a second unidirectional element (12) connected between the first power supply terminal (2) and the second node (18), and
a drive circuit (28) for driving a control electrode of the first switching transistor (6) as claimed in Claim 1, 2, 3, 4 or 5.

## Patentansprüche

1. Treiberschaltung zur Ansteuerung einer Steuerelektrode eines Schalttransistors (6) mit einem Hauptstrompfad in Reihe mit einer Primärwicklung (14) eines Transformators, der zwischen einen ersten (2) und einen zweiten (4) Stromversorgungsanschluß geschaltet ist, wobei die Treiberschaltung folgendes umfaßt:
einen Anlaßwiderstand (42), der zwischen die Steuerelektrode des Schalttransistors (6) und den ersten Stromversorgungsanschluß (2) geschaltet ist,
eine Sekundärwicklung (30) des Transformators mit einem ersten Anschluß (32) und einem zweiten Anschluß (34), wobei der zweite Anschluß (34) in einem Knotenpunkt (16) mit einer ersten Hauptelektrode des Schalttransistors (6) verbunden ist,
einen Koppelkondensator (36) und einen Reihenwiderstand (38, 40), die zwischen den ersten Anschluß (32) der Sekundärwicklung (30) und die Steuerelektrode des Schalttransistors (6) in Reihe geschaltet sind, und
eine Entladungsdiode (44), die zwischen den zweiten Anschluß (34) der Sekundärwicklung (30) und einen Abgriff des Reihenwiderstands (38, 40) geschaltet ist,
dadurch gekennzeichnet, daß die Treiberschaltung weiterhin folgendes umfaßt:
eine Spannungsquelle (46, 48, 52) mit einem ersten Spannungsanschluß (34), der mit dem genannten Knotenpunkg (16) der ersten Hauptelektrode des Schalttransistors (6) verbunden ist, und mit einem zweiten Spannungsanschluß (50) zur Lieferung einer Vorspannung, die in bezug auf den Knotenpunkt (16) höher ist als die Durchlaßspannung der Entladungsdiode (44) und das gleiche Vorzeichen hat, und
einen weiteren Schalttransistor (54) von einem Leitfähigkeitstyp, der dem Leitfähigkeitstyp des erstgenannten Schalttransistors (6) entgegengesetzt ist, wobei der weitere Schalttransistor (54) eine erste Hauptelektrode hat, die mit der Steuerelektrode des erstgenannten Schalttransistors (6) verbunden ist, eine zweite Hauptelektrode, die mit dem Spannungsanschluß (50) verbunden ist, und eine Steuerelektrode, die mit einem Knotenpunkt zwischen dem Koppelkondensator (36) und dem Reihenwiderstand (38) verbunden ist.

2. Treiberschaltung nach Anspruch 1, dadurch gekennzeichnet, daß die Spannungsquelle (46, 48, 52) folgendes umfaßt: eine Gleichrichterdiode (46) und einen Glättungskondensator (52), die in Reihe mit dem ersten Anschluß (32) und dem zweiten Anschluß (34) der Sekundärwicklung (30) angeordnet sind, wobei der Spannungsanschluß (50) durch einen Anschluß des Glättungskondensators (52) gebildet wird, welcher mit der dritten Gleichrichterdiode (46) gekoppelt ist.

3. Treiberschaltung nach Anspruch 2, dadurch gekennzeichnet, daß die Steuerelektrode des weiteren Schalttransistors (54) über einen Widerstand (60) mit dem Knotenpunkt zwischen dem Koppelkondensator (36) und dem Reihenwiderstand (38) verbunden ist, und eine Diode (58) parallel zu der Steuerelektrode und der ersten Hauptelektrode des weiteren Schalttransistors (54) angeordnet ist.

4. Treiberschaltung nach Anspruch 2, dadurch gekennzeichnet, daß die Steuerelektrode des weiteren Schalttransistors (54) über eine Reihenanordnung einer Diode (58) und eines Widerstands (60) mit dem Knotenpunkt zwischen dem Koppelkondensator (36) und dem Reihenwiderstand (38) verbunden ist, und ein weiterer Widerstand (56) parallel zu der Steuerelektrode und der ersten Hauptelektrode des weiteren Schalttransistors (54) angeordnet ist.

5. Treiberschaltung nach Anspruch 1, 2, 3 oder 4, dadurch gekennzeichnet, daß die Entladungsdiode (44) eine Zener-Diode ist.

6. Stromversorgungsschaltung mit zwei Schalttransistoren (6, 8) in einer Brückenanordnung, die folgendes umfaßt:
einen Transformator mit einer Primärwicklung (14), die zwischen einen ersten (16) und einen zweiten (18) Knotenpunkt geschaltet ist;
einen ersten Schalttransistor (6) mit einem Hauptstrompfad, der zwischen einen ersten Stromversorgungsanschluß (2) und den ersten Knotenpunkt (16) geschaltet ist;
einen zweiten Schalttransistor (8) mit einem Hauptstrompfad, der zwischen den zweiten Knotenpunkt (18) und einen zweiten Stromversorgungsanschluß (4) geschaltet ist;
Mittel (26) zum Ansteuern einer Steuerelektrode des zweiten Schalttransistors (8);
ein erstes unidirektionales Element (10), das zwischen den ersten Knotenpunkt (16) und den zweiten Stromversorgungsanschluß (4) geschaltet ist;
ein zweites unidirektionales Element (12), das zwischen den ersten Stromversorgungsanschluß (2) und den zweiten Knotenpunkt (18) geschaltet ist; und
eine Treiberschaltung (28) zur Ansteuerung einer Steuerelektrode des ersten Schalttransistors (6) nach Anspruch 1, 2, 3, 4 oder 5.

## Revendications

1. Circuit d'attaque pour attaquer une électrode de commande d'un transistor de commutation (6) ayant un trajet de courant principal en série avec un enroulement primaire (14) d'un transformateur connecté entre une première (2) et une deuxième (4) bornes d'alimentation, lequel circuit d'attaque comprend :
une résistance d'amorçage (42) connectée entre l'électrode de commande du transistor de commutation (6) et la première borne d'alimentation (2),
un enroulement secondaire (30) du transformateur ayant une première borne (32) et une deuxième borne (34), laquelle deuxième borne (34) est connectée à une première électrode principale du transistor de commutation (6) dans un noeud (16),
un condensateur de couplage (36) et une résistance en série (38, 40), qui sont montés en série entre la première borne (32) de l'enroulement secondaire (30) et l'électrode de commande du transistor de commutation (6), et
une diode de décharge (44) montée entre la deuxième borne (34) de l'enroulement secondaire (30) et une prise de la résistance en série (38, 40), caractérisé en ce que le circuit d'attaque comprend en outre :
une source de tension (46, 48, 52) ayant une première borne de tension (34) connectée audit noeud (16) de la première électrode principale du transistor de commutation (6) et ayant une deuxième borne de tension (50) pour délivrer une tension de polarisation qui, par rapport au noeud (16), est plus élevée et de même signe que la tension directe de la diode de décharge (44), et un autre transistor de commutation (54) d'un type de conductivité opposé au type de conductivité du premier transistor de commutation mentionné (6), lequel autre transistor de commutation (54) a une première électrode principale connectée à l'électrode de commande du premier transistor de commutation mentionné (6), une deuxième électrode principale connectée à la borne de tension (50) et une électrode de commande couplée à un noeud entre le condensateur de couplage (36) et la résistance en série (38).

2. Circuit d'attaque suivant la revendication 1, caractérisé en ce que la source de tension (46, 48, 52) comprend : une diode redresseuse (46) et un condensateur de lissage (52), qui sont montés en série entre la première borne (32) et la deuxième borne (34) de l'enroulement secondaire (30), la borne de tension (50) étant formée par une borne du condensateur de lissage (52), laquelle borne est couplée à la troisième diode redresseuse (46).

3. Circuit d'attaque suivant la revendication 2, caractérisé en ce que l'électrode de commande de l'autre transistor de commutation (54) est connectée au noeud entre le condensateur de couplage (36) et la résistance en série (38) via une résistance (60), et une diode (58) est montée aux bornes de l'électrode de commande et de la première électrode principale de l'autre transistor de commutation (54).

4. Circuit d'attaque suivant la revendication 2, caractérisé en ce que l'électrode de commande de l'autre transistor de commutation (54) est connectée au noeud entre le condensateur de couplage (36) et la résistance en série (38) via un montage en série d'une diode (58) et d'une résistance (60), et une autre résistance (56) est montée aux bornes de l'électrode de commande et de la première électrode principale de l'autre transistor de commutation (54).

5. Circuit d'attaque suivant la revendication 1, 2, 3 ou 4, caractérisé en ce que la diode de décharge (44) est une diode Zener.

6. Circuit d'alimentation comprenant deux transistors de commutation (6, 8) dans un montage en pont comprenant :
un transformateur ayant un enroulement primaire (14) monté entre un premier noeud (16) et un deuxième noeud (18);
un premier transistor de commutation (6) dont le trajet de courant principal est connecté entre une première borne d'alimentation (2) et le premier noeud (16);
un deuxième transistor de commutation (8) dont le trajet de courant principal est connecté entre le deuxième noeud (18) et une deuxième borne d'alimentation (4);
un moyen (26) pour attaquer une électrode de commande du deuxième transistor de commutation (8);
un premier élément unidirectionnel (10) connecté entre le premier noeud (10) et la deuxième borne d'alimentation (4);
un deuxième élément unidirectionnel (12) connecté entre la première borne d'alimentation (2) et le deuxième noeud (18), et
un circuit d'attaque (28) pour attaquer une électrode de commande du premier transistor de commutation (6) suivant la revendication 1, 2, 3, 4 ou 5.
